# EUROPEAN PATENT APPLICATION

(11) **EP 1 887 843 A1**
(43) Date of publication of application: **13.02.2008**
(21) Application number: 06732458.2
(22) Date of filing: 28.04.2006
(51) Int. Cl.: H05K 1/16, H05K 3/46, C04B 35/64, H01G 4/12, H01G 4/33, H01G 13/00

(54) **METHOD FOR OXIDE DIELECTRIC LAYER FORMATION, AND CAPACITOR LAYER FORMING MATERIAL COMPRISING OXIDE DIELECTRIC LAYER FORMED BY SAID FORMATION METHOD**

(30) Priority: 28.04.2005 JP 2005133694
(71) Applicant: MITSUI MINING & SMELTING CO., LTD., Tokyo 141-8584 (JP)
(72) Inventor: KANNO, Akihiro c/o MITSUI MINING & SMELTING, Ageo-shi Saitama 3620021 (JP); SUGIOKA, Agiko c/o MITSUI MINING & SMELTING, Ageo-shi Saitama 3620021 (JP); ABE, Naohiko c/o MITSUI MINING & SMELTING, Ageo-shi Saitama 3620021 (JP); NAKASHIMA, Hirotake c/o MITSUI MINING & SMELTING, Ageo-shi Saitama 3620021 (JP)
(74) Representative: Bohmann, Armin K.
(86) International application number: PCT/JP2006/308955
(87) International publication number: WO 2006/118236

(57) **Abstract**

The present invention has an object to provide a method for forming an oxide dielectric layer, which dielectric layer is formed by applying the sol-gel method, and is hardly damaged by an etching solution and excellent in dielectric characteristics such as a large electric capacitance. To achieve the object, the forming method of an oxide dielectric layer by applying a sol-gel method **characterized by** being provided with the following processes (a) to (c) is employed. Process (a): A solution preparing process of preparing a sol-gel solution for manufacturing an aiming oxide dielectric layer. Process (b) : A coating process wherein stages of the sol-gel solution coating on the surface of a metal substrate followed by drying in an oxygen-containing atmosphere followed by pyrolysis in an oxygen-containing atmosphere sequentially is made one unit step; the one unit step is repeated twice ormore times; and a pre-baking stage at 550-deg. C to 1000-deg. C in an inert gas-substituted atmosphere or the like is provided optionally between the one unit step and the next one unit step to control the film thickness. Process (c): A baking process of finally subjecting the coated metal substrate to a baking process at 550-deg.C to 1000-deg.C in an inert gas-substituted atmosphere or the like to finish the dielectric layer.

## Description

### Technical Field

The invention according to the present application relates to a capacitor layer forming material and a manufacturing method of the capacitor layer forming material and a printed wiring board provided with an embedded capacitor layer obtained by using the capacitor layer forming material.

### Background Art

A capacitor layer forming material mentioned in the present invention has a constitution having a dielectric layer between a first conductive layer used for forming a top electrode and a second conductive layer used for forming a bottom electrode. As disclosed in Patent Document 1, the first conductive layer and the second conductive layer are processed to form capacitor circuits by etching and the like, and are generally used as materials constituting electronic materials of printed wiring boards and the like.

The dielectric layer has an insulation property, and is a layer to store a certain amount of electric charge. Various methods are employed for forming such a dielectric layer, but the methods generally apply the chemical vapor deposition method (CVD method), sputtering deposition method and sol-gel method. For example, as a method applying the chemical vapor deposition method, Patent Document 2 discloses a manufacturing method comprising the processes of depositing an amorphous SrTiO₃-base thin film on a substrate at a low temperature of less than 400-deg.C, and crystallizing the amorphous SrTiO₃-base thin film by laser annealing or rapid thermal annealing to obtain a SrTiO₃-based thin film. This method has an object to obtain a SrTiO₃-based thin film having a high dielectric constant.

Then, as a thin film capacitor applying the sputtering deposition method, Patent Document 3 discloses a thin film capacitor in which a bottom electrode, a dielectric having a high dielectric constant and a top electrode are stacked on an optional layer on a substrate, and is characterized in that the dielectric having a high dielectric constant is a polycrystal composed of crystal grains and crystal grain boundaries, contains metal ions capable of taking a plurality of valences as impurities, and contains the higher-concentration impurities in the vicinity of the crystal grain boundaries than those inside the crystal grains, and discloses that as the metal ions capable of taking the plurality of valences, Mn ion is suitable. The thin film capacitor obtained by this method is described to have higher long-period reliability and take a long time for dielectric breakdown.

Further, Patent Document 4 discloses, as a method applying the sol-gel method, a manufacturing method subjecting the surface of a substrate to hydroxylation and then forming on the substrate an oxide dielectric thin film using a metal alkoxide as a raw material. The oxide dielectric formed as a thin film is a metal oxide having a dielectric characteristic, which is herein exemplified by LiNbO₃, Li₂B₄O₇, PbZrTiO₃, BaTiO₃, SrTiO₃, PbLaZrTiO₃, LiTaO₃, ZnO and Ta₂O₅. The oxide dielectric thin film obtained by this method is described to have an excellent orientation and a favorable crystallinity.

The formation of a dielectric layer applying the sol-gel method has advantages over the formation of dielectric layers applying the chemical vapor deposition method (CVD method) or sputtering deposition method, such as no need of using a vacuum process and easiness of forming a dielectric layer on a wide-area substrate. Moreover, since the sol-gel method can easily make constituents of a dielectric layer in a theoretical proportion and provide a remarkably thin dielectric layer, it is expected to provide a material to form capacitor layers having large capacitance.

A manufacturing method of a PZT thin film disclosed in Patent Document 5 is characterized by comprising the processes of forming a buffer layer composed of PbTiO₃ (PT) as a main component on a substrate, then applying a thin film material composed of PZT as a main component before the buffer layer composed of PbTiO₃ as a main component is pyrolyzed of organics and thermally treating the both layers together at 430-deg.C to 500-deg.C for crystallization after both of the layers are pyrolyzed of organics. The buffer layer mentioned herein has an anticipated advantage of reducing energy to crystallize PZT at a low temperature in forming a film of PZT by fully utilize the characteristic that the crystal structure and lattice constant of PT are close to PZT. The manufacture of dielectric layers by applying the sol-gel method is advantageous as a low-temperature baking method while otherwise general methods require crystallization by the high-temperature baking and there possibly arise various problems.

Patent Document 1: National Publication of International Patent Application No. 2002-539634
Patent Document 2: Japanese Patent Laid-Open No. 06-140385
Patent Document 3: Japanese Patent Laid-Open No. 2001-358303
Patent Document 4: Japanese Patent Laid-Open No. 07-294862
Patent Document 5: Japanese Patent No. 3427795

However, dielectric layers obtained by applying the sol-gel method have a problem of a low production yield. It is because of the unevenness of their thickness due to their thinness and the presence of gaps between oxide particles, and sometimes shows a large leak current caused by short circuit between a top electrode and a bottom electrode in a formed capacitor. In particular when the electrode area is made wide to increase the electric capacitance as a capacitor, defective rate by the short circuit phenomenon in the products become serious.

In general, capacitor circuits have realized power savings of electronic and electrical equipment and the like by storing excess electricity or the like. Therefore, the capacitor circuits are required to have an electric capacitance as large as possible, which is a basic requirement. The capacitance (C) of a capacitor is calculated with the formula C= [epsilon][epsilon]₀(A/d) ([epsilon]₀ is a dielectric constant of vacuum). In particular, the recent tendency of downsizing of electric devices faces the similar requirement on printed wiring boards, a larger capacitance of capacitor circuits in a substrate area of certain printed wiring boards and the like is sometimes required even when a large surface area (A) is shared for capacitor electrodes.

In the process for conventional capacitor circuits formation, after a dielectric layer is formed as a film on a substrate such as a metal foil for forming a bottom electrode by applying the sol-gel method, a copper layer to be a top electrode is formed as a film on the dielectric layer by the sputtering method and the like and then patterning of the copper layer into a predetermined capacitor circuit by conducting the wet etching method. However, an etching solution in wet etching penetrates into the dielectric layer and reaches to the metal foil of the substrate. If such a phenomenon occurs, the substrate dissolves out and the dielectric layer may be removed also. Such penetration of the etching solution into the dielectric layer cause a rise in dielectric loss and adversely affects electric characteristics such as the increase of capacitance density in apparent. Further, dissolving-out of the substrate and damage to the dielectric layer causes short circuit between the top electrodes and the bottom electrodes (substrates). Then the production yield of the capacitor circuit decreases. In particular, when capacitor foils for embedded passive devices are manufactured, without raise product costs,used materialconstituting bottom electrodes is preferably be an inexpensive base metal foil; and top electrodes can desirably be patterned by conventional wet etching desirably without deteriorating characteristics.

Further, when PZT thin films as a dielectric layer are obtained by the low-temperature baking method as is disclosed in Patent Document 5, since a buffer layer to promote crystallization of PZT is necessary. It means that the manufacturing process might be complicated and complication of the management in process control and manufacturing cost may results the total manufacturing cost up, so it is not preferable. Moreover, the dielectric layer obtained by the method disclosed in Patent Document 5 has a disadvantage of hardly providing a dielectric layer having large-capacitance because of a large total thickness as a dielectric layer due to the presence of a buffer layer and the use of PT, which has a poor quality as a dielectric.

As shown above, it has been desired in the market that dielectric layers are formed by applying the sol-gel method which has superior advantage in the manufacturing cost, the dielectric layers are hardly damaged by an etching solution, and the dielectric layers have a high electric capacitance. In addition, the forming method of the dielectric layers has been demanded to have a high production yield.

### Disclosure of the Invention

After extensive attempts of investigations where forming oxide crystal grains of a dielectric layer by applying the sol-gel method made fine to be a not-conventionally available level, or forming coarse grains having few crystal boundaries are obtained, the present inventors has achieved the following invention.

The forming method of an oxide dielectric layer according to the present invention: The forming method of an oxide dielectric layer according to the present invention is applying the sol-gel method which is characterized by comprising the following processes of (a) to (c).

(a) A solution preparing process of preparing a sol-gel solution for manufacturing an aiming oxide dielectric layer;
(b) A coating process of controlling a film thickness wherein sequential one unit step in which the sol-gel solution is applied on a surface of a metal substrate followed by drying at 120-deg.C to 250-deg.C in an oxygen-containing atmosphere and thermally decompose at 270-deg.C to 390-deg.C in an oxygen-containing atmosphere is repeated twice or more times, and between the unit steps, a pre-baking stage at 550-deg.C to 1000-deg.C in an inert gas-substituted atmosphere or in vacuum is provided optionally; and
(c) A baking process of finally subjecting the coated metal substrate to a baking process at 550-deg. C to 1000-deg. C in an inert gas-substituted atmosphere or in vacuum to finish a dielectric layer.

The sol-gel solution used in the forming method of the oxide dielectric layer according to the present invention is preferably the sol-gel solution to form a (Ba₁₋ₓSrₓ)TiO₃ (0 <= x <=1) film or a BiZrO₃ film as the oxide dielectric layer.

Further, the sol-gel solution to form the oxide dielectric layer according to the present invention preferably contains 0.01 mol% to 5.00 mol% of one or a mixture selected from manganese, silicon, nickel, aluminum, lanthanum, niobium, magnesium and tin.

The dielectric layer obtained by the forming method of the oxide dielectric layer according to the present invention preferably has a thickness of 20-nano meter to 2-micron meter.

The metal substrate used in the forming method of the oxide dielectric layer according to the present invention is preferably anyone of a nickel foil, a nickel alloy foil, a composite foil having a nickel layer on its surface and a composite foil having a nickel alloy layer on its surface, which have a thickness of 1-micron meter to 100-micron meter.

The metal substrate, nickel alloy foil or the nickel alloy layer of the composite foil having the nickel alloy layer on its surface is preferably nickel-phosphorus alloy.

The capacitor layer forming material according to the present invention: The capacitor layer forming material according to the present invention is preferably obtained by the method described in one of the above-mentioned manufacturing methods in which a dielectric layer is provided between a first conductive layer used for forming a top electrode and a second conductive layer used for forming a bottom electrode, characterized in that the dielectric layer is obtained by the method for forming an oxide dielectric layer.

The printed wiring board according to the present invention: By using the capacitor layer forming material according to the present invention, a printed wiring board having an embedded capacitor layer of an excellent quality can be obtained.

The forming method of an oxide dielectric layer by applying the sol-gel method according to the present invention can form an oxide dielectric layer of an excellent quality with high yield. The dielectric layer obtained by the forming method of an oxide dielectric layer according to the present invention reduce the leak current and is hardly damaged by an etching solution, and is suitable for forming capacitor circuits by using etching method. The capacitor layer forming material in which a dielectric layer is formed by applying the forming method of an oxide dielectric layer by applying the sol-gel method according to the present invention is suitable for forming capacitor layers in printed wiring boards, and allows manufacture of capacitor circuits exhibiting a large electric capacitance and a low dielectric loss.

### Brief Description of the Drawings

Figure 1 is a cross-sectional image of a capacitor layer forming material in which an oxide dielectric layer is formed by applying the sol-gel method according to the present invention observed by a transmission electron microscope after processing by focused ion beams;
Figure 2 is a cross-sectional image of a capacitor layer forming material in which an oxide dielectric layer is formed by applying the sol-gel method according to the present invention observed by a transmission electron microscope after processing by focused ion beams;

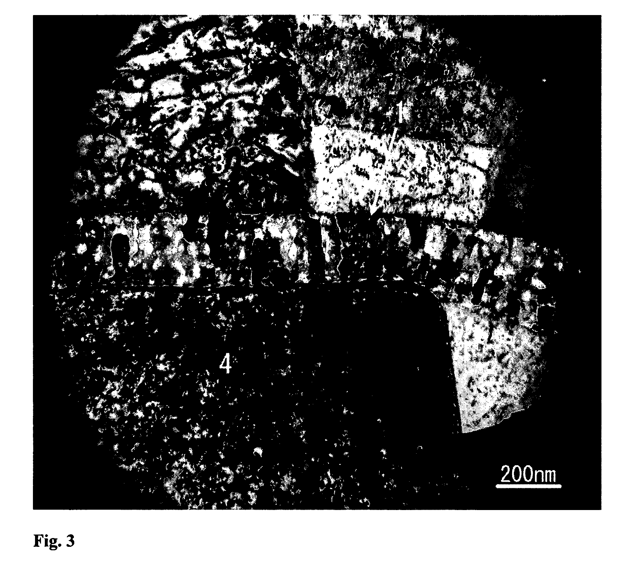

Figure 3 is a cross-sectional image of a capacitor layer forming material in which an oxide dielectric layer is formed by applying the sol-gel method according to the present invention observed by a transmission electron microscope after processing by focused ion beams;
Figure 4 is a cross-sectional image of a capacitor layer forming material observed by a transmission electron microscope after processing by focused ion beams (conventional example);
Figure 5 is an image of the interface part between a second conductive layer and a dielectric layer of a capacitor layer forming material observed by a transmission electron microscope after processing by focused ion beams;
Figure 6 is an image of the interface part between a second conductive layer and a dielectric layer of a capacitor layer forming material observed by a transmission electron microscope after processing by focused ion beams;
Figure 7 is an illustrative view showing a manufacturing flow of a printed wiring board with the embedded capacitor circuits using the capacitor layer forming material according to the present invention;
Figure 8 is an illustrative view showing a manufacturing flow of a printed wiring board with the embedded capacitor circuits using the capacitor layer forming material according to the present invention;
Figure 9 is an illustrative view showing a manufacturing flow of a printed wiring board with the embedded capacitor circuits using the capacitor layer forming material according to the present invention; and
Figure 10 is an illustrative view showing a manufacturing flow of a printed wiring board with the embedded capacitor circuit using the capacitor layer forming material according to the present invention.

### Description of Symbols

- 1, 13: dielectric layer
- 2: first layer
- 3, 15: top electrode
- 4, 19: bottom electrode
- 5: heterogeneous phase
- 10: printed wiring board
- 11: capacitor layer forming material
- 12: first conductive layer
- 14: second conductive layer
- 16: copper foil layer
- 17: semi-cured resin layer
- 17': insulating layer
- 18: resin-coated copper foil
- 21: etching resist layer
- 22: outer layer circuit
- 23: via hole
- 24: copper plating layer

### Best Mode for Carrying Out the Invention

### <The forming method of an oxide dielectric layer according to the present invention>

The forming method of an oxide dielectric layer according to the present invention is a forming method of an oxide dielectric layer by applying the sol-gel method, and is characterized by comprising the following processes of (a) to (c). Hereinafter, every process will be described one by one.

First, for easy understanding of features of the present invention, the formation of oxide dielectric layers by applying the conventional sol-gel method that the present inventors have performed will be briefly described. The formation of oxide dielectric layers used for conventional dielectric layers generally undergoes the processes of (I) to (III).

(I) A solution preparing process of preparing a sol-gel solution for manufacturing an aiming oxide dielectric layer;
(II) A coating process in which the sol-gel solution is coated on the surface of a substrate, dried at 120-deg. C to 250-deg. C for 30 sec. to 10 min. in an oxygen-containing atmosphere and pyrolyzed at 450-deg.C to 550-deg.C for 5 min to 30 min in an oxygen-containing atmosphere is repeated twice or more times to control the film thickness, and the process of (II) is repeated twice or more times to control the film thickness to an aiming one; and (III) A baking process of subjecting the coated metal substrate to a baking process at 550-deg.C to 800-deg.C for 5 min to 60 min in an inert gas-substituted atmosphere or in vacuum as a final baking to make a dielectric layer. By undergoing the above processes, oxide dielectric layers have been formed.

As is clear from above, in the formation of oxide dielectric layers by applying the conventional sol-gel method, the baking is only one time at the final stage. In contrast, the present invention establishes the pre-baking once or more times between one unit step and next one unit step to form oxide dielectric layers.

Process (a) : This process is a solution preparing process of preparing a sol-gel solution for manufacturing an aiming oxide dielectric layer. This process is not especially limited, and may use commercially available agents for the preparation or arrange the formulation by oneself. It is sufficient if either one of a (Ba₁₋ₓSrₓ)TiO₃ (0 <= x <=1) film or a BiZrO₃ film can eventually be obtained as the desired oxide dielectric layer. Herein, the (Ba₁₋ₓSrₓTiO₃ (0 <= x <=1) film, if x = 0, it is the composition of BaTiO₃; and if x = 1, SrTiO₃. As intermediate compositions, there are (Ba_{0.7}Sr_{0.3})TiO₃ and the like.

Further, in consideration of mechanisms of the occurrence of the leak current through a dielectric layer, it came clear that the leak current flows highly possibly through crystal grain boundaries and lattice defects of the oxide dielectric layer in the case of an oxide dielectric layer formed by applying the sol-gel method. That is, a finer texture of the oxide dielectric layer, more crystal grain boundaries and a higher density of internal defect in the crystals result a bigger leak current. Countermeasures of this point will be described later, but depending on the composition of an oxide dielectric layer, the reducing of leak current and improving quality of a dielectric layer are possible.

Specifically, it is preferable to contain one or a mixture selected from manganese, silicon, nickel, aluminum, lanthanum, niobium, magnesium and tin in crystal grain boundaries and crystal grains of the oxide dielectric layer. These components are considered to exist as oxides in a dielectric layer; and the oxides are segregated most preferentially in crystal grain boundaries of the oxide dielectric layer obtained by applying the sol-gel method, and used to prevent a flow of the leak current. Therefore, these components are referred to as "leak preventive component". Among the leak preventive components, manganese is preferably used. This is because manganese is easily segregated in crystal grain boundaries of an oxide dielectric layer obtained by applying the sol-gel method. At this time, the amount of the leak preventive component to be contained in the oxide dielectric layer is preferably 0.01 mol% to 5.00 mol%. Herein, when two or more components are used, the amount of the leak preventive component means the total amount of the components. With the amount of the leak preventive component of less than 0.01 mol%, the leak preventive component is insufficiently segregated in crystal grain boundaries of an oxide dielectric layer obtained by applying the sol-gel method, not providing a favorable effect on the reducing of leak current. In contrast, with the amount of the leak preventive component exceeding 5.00 mol%, the leak preventive component is excessively segregated in crystal grain boundaries of an oxide dielectric layer obtained by applying the sol-gel method, the dielectric layer may become brittle and lose toughness thereof and resulting in easy occurring of problems such as breakage of the dielectric layer due to an etching solution shower and the like when a top electrode shape and the like are processed by etching. An excess amount of a leak preventive component also has a tendency of suppressing the growth of an oxide crystal structure by a manufacturing method described below. Therefore, employment of a leak preventive component containing a composition in the above-mentioned range increases the electric capacitance as a capacitor, accomplishes a reducing leak current, and prolongs service life. More preferably, the amount of a leak preventive component contained in the oxide dielectric layer is 0.25 mol% to 1.50 mol%. This is for more surely assuring the quality of the oxide dielectric layer. Herein, an oxide dielectric layer means a dielectric film having the perovskite structure. And it does not contain manganese oxide unless it is clearly shown on containing of a manganese oxide component.

Also, it may be supposed that a leak preventive component including manganese is substituted and arranged in an oxide crystal lattice. Oxide dielectric layers generally generate oxygen lack by the crystallization in a low oxygen partial pressure. This reduces the valence of titanium from tetravalent to trivalent, and electron hopping between titanium atoms of the different valences is said to cause decrease in the insulation. However, when a suitable amount of a leak preventive component is substituted and dissolved as a solid in an oxide crystal, the leak preventive component takes a bivalent or trivalent atomic construction and can compensate for the oxygen lack, and is expected to have an effect of improving the insulation by preventing the reduction of titanium.

The oxide dielectric layer formed by the method according to the present invention preferably has a thickness of 20-nano meter to 2-micron meter. This is because since a thinner dielectric layer provides a more improved electric capacitance, the thinner one is preferable. However, if the thickness of a dielectric layer is less than 20-nano meter, even if manganese, silicon or the like is added to a dielectric layer as described above, the effect of reducing the leak current diminishes and the service life cannot be prolonged because the dielectric breakdown occurs earlier. In contrast, since a thick dielectric layer increases the insulation reliability, the thick dielectric layer may be allowed depending on the balance with the electric capacitance. However, when dielectric layers are formed by applying the sol-gel method, the thickness is practically approximately 2-micron meter in consideration of industrial production, and is further believed to have an upper limit of approximately 1-micron meter in consideration of market demands. Further, the thickness is more preferably not less than 50-nano meter in consideration of the size of a crystal structure of an oxide dielectric layer described later.

Process (b) : This process is a coating process wherein stages of the sol-gel solution coating on the surface of a metal substrate (hereinafter, for the descriptive convenience, referred to as just "coating") followed by drying in an oxygen-containing atmosphere (hereinafter, for the descriptive convenience, referred to as just "drying") followed by thermal decomposition in an oxygen-containing atmosphere (hereinafter, for the descriptive convenience, referred to as just "pyrolysis") sequentially is made one unit step, and in repeating of the one unit step twice or more times, a pre-baking stage at 550-deg.C to 1000-deg.C in an inert gas-substituted atmosphere or in vacuum is provided between the unit steps optionally, and then the film thickness is adjusted.

That is, in this step, a sequential successive stage of coating, drying, pyrolysis is referred to as one unit step. In conventional methods, after such one unit step is repeated simply twice or more times, the baking is conducted finally. In contrast, in the present invention, a pre-baking stage of at least once is provided between the unit steps repeating twice or more times. Therefore, for example, in the case of repeating the one unit step six times and providing the pre-baking stage once, a process of one unit step (first time), the pre-baking stage, one unit step (second time), one unit step (third time), one unit step (fourth time), one unit step (fifth time), one unit step (sixth time), or otherwise, is employed. In the case of providing the baking stages twice, a process of one unit step (first time), the pre-baking stage, one unit step (second time), one unit step (third time), the pre-baking stage, one unit step (fourth time), one unit step (fifth time), one unit step (sixth time), or otherwise, is employed. Further, in the case of providing the pre-baking stages all between one unit steps, a process of one unit step (first time), the pre-baking stage, one unit step (second time), the pre-baking stage, one unit step (third time), the pre-baking stage, one unit step (fourth time), the pre-baking stage, one unit step (fifth time), the pre-baking stage, one unit step (sixth time) is employed.

In the crystal state of oxide dielectric layers obtained by applying the conventional sol-gel method, fine crystal grains exist and a large number of voids are found within the crystal grains. It is believed because of volatilization of organic components contained in a sol-gel solution at baking. If wet etching is performed in such a state, an etching solution easily penetrates into a dielectric layer. Therefore, when a top electrode is patterned by etching, a substrate (a constituting material of a bottom electrode) is eroded by the etching solution having penetrated through the dielectric layer and the part of the eroded portions that had been on the eroded part of the bottom electrode of the dielectric layer break off and disappear. In contrast, the employment of process (b) brings about a state of the texture of an oxide dielectric layer in which the film density is highly dense and there are few structural defects in the crystal grains. Therefore, even if the top electrode is patterned by the wet etching method as described above, a substrate (a constituting material of a bottom electrode) is prevented from eroding by etching, since the etching solution hardly penetrates through the dielectric layer, the dielectric layer is surely observed at portions where the dielectric layer should be exposed after the top electrode has been patterned by etching. As a result, a capacitor circuit provided with a dielectric layer having a low leak current and a large capacitance is provided. For most effectively preventing the penetration of an etching solution into the dielectric layer mentioned herein, in the case of repeating the one unit step six times, carrying-out of the pre-baking stage as early as possible is preferable. Therefore, ideal carrying-out of the pre-baking stage is that one unit step (first time), the pre-baking stage, and next one unit step (second time). In the case of carrying out the pre-baking stage only one time, if the pre-baking stage approaches close to the final baking as in one unit step (fifth time), the pre-baking stage, one unit step (sixth time), the significance of the pre-baking stage does not differ from the final baking, an effect of providing the pre-baking stage is weakened.

The crystal structure of an oxide dielectric layer preferably has a possibly largest grain size. This is because if the crystal structure has a possibly largest grain size, the ratio of the existence of crystal grain boundaries which may be leak paths can be reduced. Studies by the present inventors have made it clear on size of the provided crystal grain that, speaking in particular, when the coarsened crystal structure of the dielectric layer grows in both the thickness direction and the plane direction, and the grain size (major axis) contains an oxide crystal structure of 50-nano meter to 300-nano meter, the dielectric layer becomes one having a small leak current and a high electric capacitance, and further the prolonged service life withstanding a long-period usage can be accomplished. The grain size mentioned herein is the size of crystal grains obtained by measuring the major axis of coarse grains of a dielectric layer examined directly from the cross-sectional images obtained by a transmission electron microscope at magnification of x 1000000 after processed with focused ion beams. So it cannot be called the grain size in an exact meaning, but it does not have any problem to be an index to clear the presence of coarsened crystal grains. When the size of grains (major axis) of just less than 50-nano meter is observed, the dielectric layer does not exhibit an outstanding reduction in neither the leak current nor an outstanding increase in the electric capacitance as compared to oxide dielectric layers obtained by applying the conventional sol-gel method. In contrast, for providing crystal grains having a level exceeding 300-nano meter in grain size (major axis) of an oxide crystal structure constituting a dielectric layer, a remarkably special manufacturing condition must be applied, which is in the range where the production in a practical industrial scale is impossible.

Here, coating in one unit step will be described. Coating means to coat a sol-gel solution on the surface of a metal substrate is not especially limited, but preferably uses a spin coater in consideration of the uniformity of the film thickness, properties of the sol-gel solution and the like.

As the metal substrate mentioned herein, one of a nickel layer, a nickel alloy layer, a composite foil having a nickel layer on its surface layer and a composite foil having a nickel alloy layer on its surface layer is preferably used. These can be preferably used because: (1) The metal substrate is available as a metal foil and a dielectric layer can be formed on the surface of the metal foil as it is by applying the sol-gel method; (2) Oxidation resistance and softening resistance are excellent against a severe thermal history loaded when a dielectric layer is formed by applying the sol-gel method; (3) Arrangement on the nickel alloy composition allows control of the adhesion with a dielectric layer at a certain level; and (4) Fine capacitor circuits can be formed when a bottom electrode shape is formed by etching.

The nickel layer or nickel alloy layer mentioned herein is intended to use mainly a metal foil. Therefore, the nickel layer is preferably formed of a pure nickel foil having a so-called purity of not less than 99.0% (others are inevitable impurities), most preferably not less than 99.9%. With a higher-purity nickel foil, the adhesion stability between the nickel foil and a dielectric layer is improved. The nickel alloy layer is a layer formed of, for example, a nickel-phosphorus alloy. The phosphorus content of the nickel-phosphorus alloy mentioned herein is preferably 0.1 wt% to 11 wt%. When the nickel-phosphorus alloy layer is subjected to a high temperature in a manufacturing process of capacitor layer forming materials and conventional printed wiring boards, phosphorus component is believed to diffuse into the dielectric layer to deteriorate the adhesion with the dielectric layer and the dielectric constant also. However, the nickel-phosphorus alloy layer having appropriate phosphorus content improves the electric characteristics as capacitors. The case where the phosphorus content is less than 0.1 wt% does not differ from the case of using a pure nickel, losing the significance of alloying. In contrast, with the phosphorus content exceeding 11 wt%, phosphorus segregates on the interface with the dielectric layer; the adhesion with the dielectric layer is deteriorated; and the nickel-phosphorus alloy easily peeled. Therefore, the phosphorus content is preferably in the range from 0.1 wt% to 11 wt%. To assure more stable adhesion with a dielectric layer, the phosphorus content in the range from 0.2 wt% to 3 wt% allows formation of capacitor circuits having a stable quality, even if the process has certain deviation. Pointing out the optimum range, the phosphorus content in the range from 0.25 wt% to 1 wt% assures the most favorable adhesion with a dielectric layer and simultaneously assures a favorable dielectric constant. The phosphorus content in the present invention is a value in terms of [P component weight]/[Ni component weight] x 100 (wt%).

As the metal substrate in the present invention, a nickel foil, a nickel alloy foil and also others such as a composite foil having a nickel layer on its surface layer and a composite foil having a nickel alloy layer on its surface layer can be used. Namely, these foils are described as a concept containing a material like a composite foil having a nickel or nickel alloy layer on its surface. As a material constituting a metal substrate, for example, a composite foil in which a nickel layer or a nickel alloy layer is provided on the surface of a copper foil may be used. Additionally, the nickel layer or the nickel alloy layer may be provided on one side or both sides of a foil.

As long as the metal substrate has such properties, it exhibits almost no deterioration of the strength even when undergoing a high-temperature processing at 300-deg.C to 400-deg.C used in a manufacturing process of printed wiring boards using fluorine-contained resin boards, liquid crystal polymers and the like as a base material. The result means that when the metal foil or the composite foil is used as a metal substrate and a dielectric layer is formed on its surface, almost no deterioration of the metal substrate is exhibited. The nickel foil and nickel alloy foil mentioned in the present invention preferably have a crystal structure having possibly finest crystal grains and an improved strength. Further, specifically, rolled nickel foils are preferable in view of the tensile strength; and electrolytic nickel foils are preferable to have an average fine crystal grain size of a level of not more than 0.5-micron meter and a high mechanical strength.

The total thickness of the metal substrate is preferably 1-micron meter to 100-micron meter. With the thickness of less than 1-micron meter, the reliability as an electrode when capacitor circuits are formed is very low, resulting in a large difficulty in forming a dielectric layer on the surface thereof. In contrast, the thickness exceeding 100-micron meter has almost no practical needs. Further, in the case of making a second conductive layer of not more than 10-micron meter in thickness, handling becomes difficult. Then, a metal foil constituting the second conductive layer is preferably a metal foil with a carrier foil in which the metal foil is bonded with the carrier foil through the bonding interface. The carrier foil is recommended to release after the metal foil with the carrier foil has been finished into a capacitor layer forming material mentioned in the present invention. In the case of a composite foil having a nickel layer on its surface or a composite foil having a nickel alloy layer on its surface, mentioned herein, the nickel layer or nickel alloy layer preferably has a thickness of 0.1-micron meter to 3-micron meter when both composite foils have a total thickness of 1-micron meter to 100-micron meter. That is because, with the thickness of the nickel layer or nickel alloy layer of less than 0.1-micron meter, the oxidation resistance cannot be provided against a severe thermal history loaded when a dielectric layer is formed by applying the sol-gel method; in contrast, with that exceeding 3-micron meter, use thereof is not largely different from use of conventional nickel foils or nickel alloy foils in view of cost.

The respective manufacturing methods of the metal substrates described above are not especially limited, and can employ every conventional method. For example, nickel foils or nickel alloy foils can be manufactured by the electrolysis method or rolling method. The manufacturing methods thereof are not especially limited. In particular, the rolling method, which involves adjusting components of an ingot by a metallurgical process and processing the ingot into a foil by a rolling mill while subjecting the ingot to a suitable annealing, has an advantage for manufacturing nickel alloy foils, and can sufficiently employ the conventional means. In the case of a composite foil having a nickel layer on its surface layer or a composite foil having a nickel alloy layer on its surface, the nickel layer or nickel alloy layer can be formed on the surface of a metal foil such as a copper foil by the electrodeposition method, sputtering deposition method, chemical vapor deposition method or the like, described below.

For example, in the electrodeposition method, deposited metallographic structures differ depending on its electrolytic solutions, electrolysis conditions and the like, leading to having an influence on the physical strength. However, in the case of forming a nickel foil or a nickel layer, solutions known as nickel plating solutions can be widely used. The conditions include, for example, (i) a condition of using nickel sulfate of 5 g/L to 30 g/L as nickel concentration, a solution temperature of 20-deg.C to 50-deg.C, pH of 2 to 4, and a current density of 0.3A/dm² to 10A/dm²; (ii) a condition of using nickel sulfate of 5 g/L to 30 g/L as nickel concentration, potassium pyrophosphate of 50 g/L to 500 g/L, a solution temperature of 20-deg.C to 50-deg.C, pH of 8 to 11, and a current density of 0.3 A/dm² to 10 A/dm²; (iii) a condition of using nickel sulfate of 10 g/L to 70 g/L as nickel concentration, boric acid of 20 g/L to 60 g/L, a solution temperature of 20-deg. C to 50-deg. C, pH of 2 to 4, and a current density of 1 A/dm² to 50 A/dm²; and conditions of others such as popular Watt's baths.

In the case of manufacturing a nickel-phosphorus alloy foil or a nickel-phosphorus alloy layer by electrolysis, a phosphoric acid-based solution is used as an electrolytic solution. This case employs (i) a condition of nickel sulfate concentration of 120 g/L to 180 g/L, nickel chloride concentration of 35 g/L to 55 g/L, H₃PO₄ concentration of 3 g/L to 5 g/L, H₃PO₃ concentration of 2 g/L to 4 g/L, a solution temperature of 70-deg.C to 95-deg.C, pH of 0.5 to 1.5, and a current density of 5 A/dm² to 50 A/dm²; (ii) a condition of nickel sulfate concentration of 180 g/L to 280 g/L, nickel chloride concentration of 30 g/L to 50 g/L, H₃BO₃ concentration of 16 g/L to 25 g/L, H₃PO₃ concentration of 1 g/L to 5 g/L, a solution temperature of 45-deg. C to 65-deg. C, and a current density of 5 A/dm² to 50 A/dm²; and any other conditions. The nickel-phosphorus alloy layer can be formed by the electroless method using a commercially available electroless plating solution, but the method cannot satisfy the industrial production in view of the film forming rate.

Next, the drying in one unit step will be described. After finishing of coating of a sol-gel solution, it is dried at 120-deg.C to 250-deg.C in an oxygen-containing atmosphere. At this time, with the drying temperature of less than 120-deg.C, the drying within a time industrially required becomes insufficient, often causing bumping on the dielectric layer surface after later pyrolysis. In contrast, with the drying temperature exceeding 250-deg.C, the dried state is liable to be uneven, leading to causing the later pyrolysis reaction to be uneven and easily causing quality deviation among positions of an obtained dielectric layer. The time for drying is preferably employed in the range from 30 sec to 10 min. Even if 250-deg.C of the upper-limit value in the above-mentioned temperature range is employed, the case of the drying time of less than 30 sec does not provide a sufficient dried state. In contrast, even if 120-deg. C of the lower-limit value in the above-mentioned temperature range is employed, the case of the drying time exceeding 10 min causes the later pyrolysis reaction to be uneven and easily causing quality deviation among positions of an obtained dielectric layer. This drying and the pyrolysis described later are performed in an oxygen-containing atmosphere. This is, because the processes performed in a reducing atmosphere do not promote decomposition of organic substances.

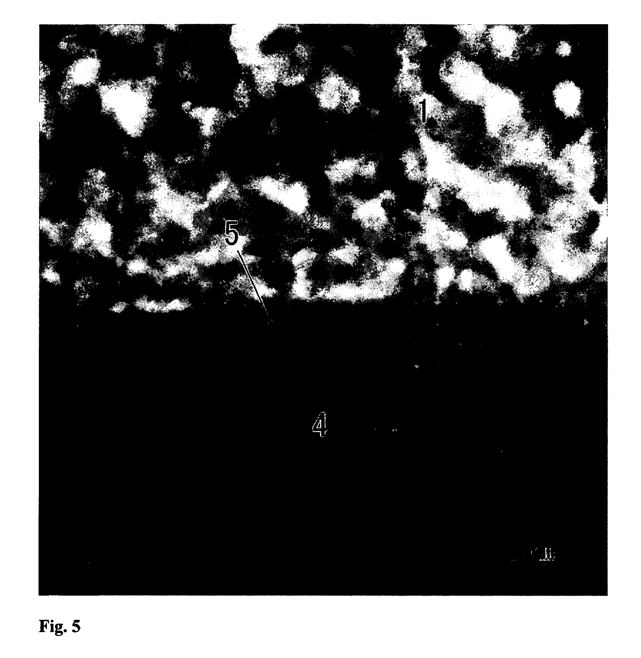

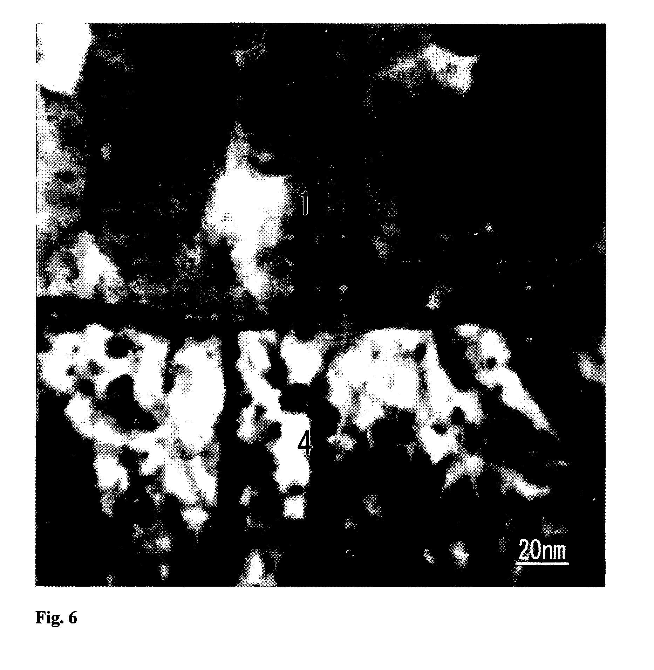

In the manufacturing method according to the present invention, employment of low temperature conditions of at 120-deg. C to 250-deg. C for drying and at 270-deg. C to 390-deg. C for pyrolysis provide one more big effect. In Figure 5 showing an image observed by a transmission electron microscope, a heterophase 5 (a layer having a different contrast in the interface between a bottom electrode 4 and a dielectric layer 1 in Figure 5) is confirmed in the interface between the bottom electrode 4 and the dielectric layer 1. This heterophase is liable to occur when the drying temperature and the pyrolysis temperature are raised, and the occurrence of the heterophase is liable to damage the adhesion between the dielectric layer and the bottom electrode and to deteriorate the dielectric characteristics. This heterophase is supposed to be a complex metal oxide of nickel oxide and others, and the like, but is not clear in detail. In contrast, employment of the conditions of the above-mentioned low-temperature drying and low-temperature pyrolysis can stably form an interface without a heterogeneous phase as in an image observed by a transmission electron microscope in Figure 6, and can provide a stable adhesion between a dielectric layer 1 and a bottom electrode 4 and favorable dielectric characteristics.

Further, the pyrolysis in one unit step will be described. After finishing of the above-mentioned drying, the pyrolysis is performed at 270-deg. C to 390-deg. C in an oxygen-containing atmosphere. Herein, the employed pyrolysis temperature is very characteristic. The conventional pyrolysis temperature has employed a temperature range from 450-deg.C to 550-deg.C. In contrast, the manufacturing method according to the present invention employs a lower pyrolysis temperature of 270-deg.C to 390-deg.C for preventing excess oxidation of a metal substrate. With the pyrolysis temperature of less than 270-deg.C, however long time the heating may be continued, favorable pyrolysis hardly occur; the productivity is poor; and favorable capacitor characteristics are not obtained. On the other hand, a dielectric layer is formed on the surface of a metal substrate, and if the heating exceeding 390-deg.C is carried out, oxidation of the surface of the metal substrate is remarkably seen at the interface between the dielectric layer and the metal substrate. However, in consideration of the deviation among processes and the quality safety in mass production, approximately 370-deg.C, which is lower than that, is preferably set to be an upper limit. The heating time should be decided by considering on an employed temperature for decomposition and properties of a sol-gel solution, but desirably employs a heating temperature range from 5 min to 30 min. When above-mentioned temperature range is employed, the heating of less than 5 min cannot perform a sufficient pyrolysis. With the heating time exceeding 30 min, the oxidation of the metal substrate surface progresses even in the above-mentioned temperature range.

A pre-baking stage provided between a one unit step and next one unit step described above involves a baking process at 550-deg.C to 1000-deg.C in an inert gas-substituted atmosphere or in vacuum. This condition is nearly same with process (c) described below, so the critical significance of numerical values and the like will be shown in the description. The baking time in the pre-baking stage is preferably 2 min to 60 min. This baking time will also be described later.

Process (c): This process is a baking process in which a dielectric layer is made by finally carrying out a baking process at 550-deg. C to 1000-deg. C in an inert gas-substituted atmosphere or in vacuum. This baking process is a so-called main baking process and a dielectric layer is finished through this baking. This baking process involves heating in an inert gas-substituted atmosphere or in vacuum for preventing the degradation due to oxidation of a metal substrate. The heating temperature at this time employs a condition of at 550-deg.C to 1000-deg.C. With the heating of less than this temperature condition, the baking within a baking time industrially required is difficult and a dielectric layer excellent in the adhesion with the metal substrate and having a crystal structure having an adequate density and a reasonable grain size cannot be obtained. In contrast, with an excess heating temperature exceeding the temperature range, deterioration of the dielectric layer and the deterioration of the substrate progress, and not accomplish a large electric capacitance and a prolonged service life as capacitor characteristics. The baking time at this baking temperature is preferably 5 min to 60 min. Even if the upper limit temperature (1000-deg.C) of the baking temperature is employed, the baking time of less than 5 min does not provide a sufficient baking and a favorable dielectric layer having a large electric capacitance. In contrast, with the baking time exceeding 60 min, even if the lower limit temperature (550-deg.C) of the baking temperature is employed, a favorable dielectric layer having a large electric capacitance cannot be obtained and the dielectric layer is liable to become brittle.

The dielectric layer manufactured by the method described above is formed directly on the surface of a metal substrate, so a buffer layer is not present between the metal substrate and the dielectric layer. Therefore, there are no complication of the manufacturing process and no rise in the total manufacturing cost, and moreover, since a buffer layer is not present, the dielectric layer manufactured by the method has advantages that the total thickness of a dielectric layer is thin and a large-capacitance dielectric layer is easily obtained.

### <The capacitor layer forming material according to the present invention>

In the capacitor layer forming material according to the present invention, in which a dielectric layer is provided between a first conductive layer used for forming a top electrode and a second conductive layer used for forming a bottom electrode, the dielectric layer is preferably obtained by a forming method of an oxide dielectric layer described in one of the manufacturing methods described above. Specifically, by using a metal foil and the like as a metal substrate to form the second conductive layer used for forming the bottom electrode, an oxide dielectric layer is formed on the surface thereof by a forming method of a dielectric layer described above. Then, the first conductive layer is formed on the obtained dielectric layer to make a capacitor layer forming material. Herein, a method of forming a first conductive layer on a dielectric layer can employ a method of using a metal foil and laminating it on the dielectric layer, a method of forming a conductive layer by the plating method, a sputtering deposition method and the like.

### <A printed wiring board using the capacitor layer forming material according to the present invention>

By using the capacitor layer forming material according to the present invention, a printed wiring board which is characterized by having a high-quality embedded capacitor layer can be provided.

The capacitor layer forming material according to the present invention can suitably be used for forming embedded capacitor layers in multilayer printed wiring boards. A first conductive layer and a second conductive layer of the capacitor layer forming material is formed into a capacitor circuit shape by etching, and used as a constituting material of multilayer printed wiring boards. By using nickel or a nickel alloy described above as a second conductive layer, a bottom electrode excellent in the adhesion with a dielectric layer can be formed; and since the bottom electrode is a material excellent in thermal resistance, though it undergoes twice or more times of a hot press in the range from 300-deg.C to 400-deg.C, it causes no oxidation deterioration and hardly causes changes in physical properties. Manufacturingmethods of printed wiring boards having embedded capacitor circuits by using the capacitor layer forming material according to the present invention are not especially limited and any method can be employed.

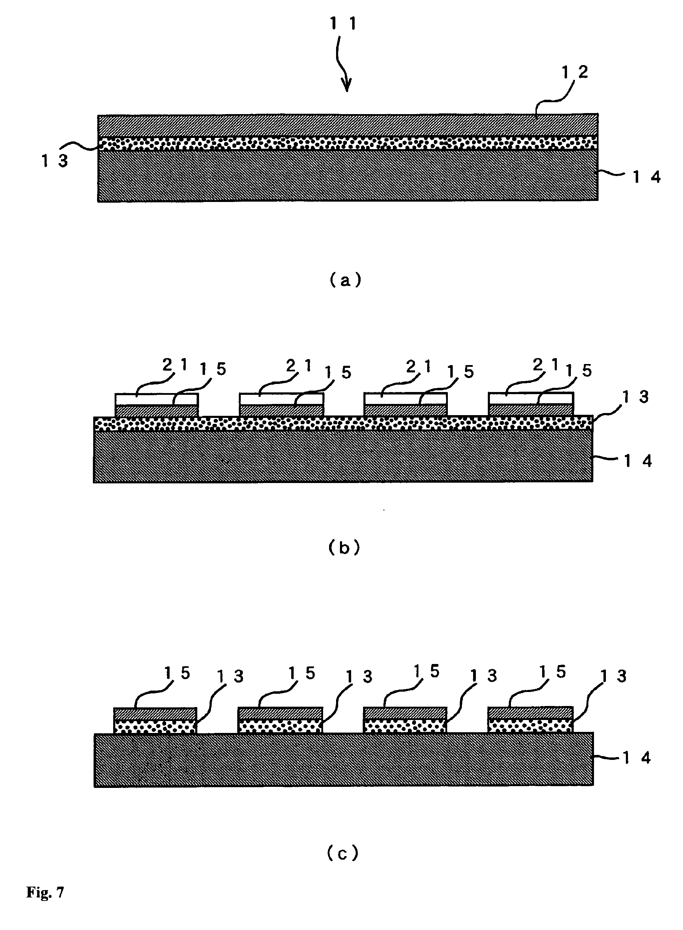

One example of the manufacturing methods of printed wiring boards will be shown. For example, a first conductive layer 12 of a capacitor layer forming material 11 shown in Figure 7(a) is polished; and a dry film resist is laminated on both surface of the capacitor layer forming material 11 to form an etching resist layer 21. An etching pattern to form a top electrode is exposed on the etching resist layer on the surface of the first conductive layer, and the etching resist layer is developed. Then, the first conductive layer 12 is etched with a copper chloride etching solution to form the top electrode 15 shown in Figure 7(b).

After the formation of the top electrode 15, the dielectric layer exposing in a region except a circuit region is removed in a state that the etching resist remain on the circuit surface. The removal method of the dielectric layer at this time preferably uses the wet blast method. After finishing the wet blast, the etching resist is released, and the resultant is washed with water and dried to be a state shown in Figure 7(c).

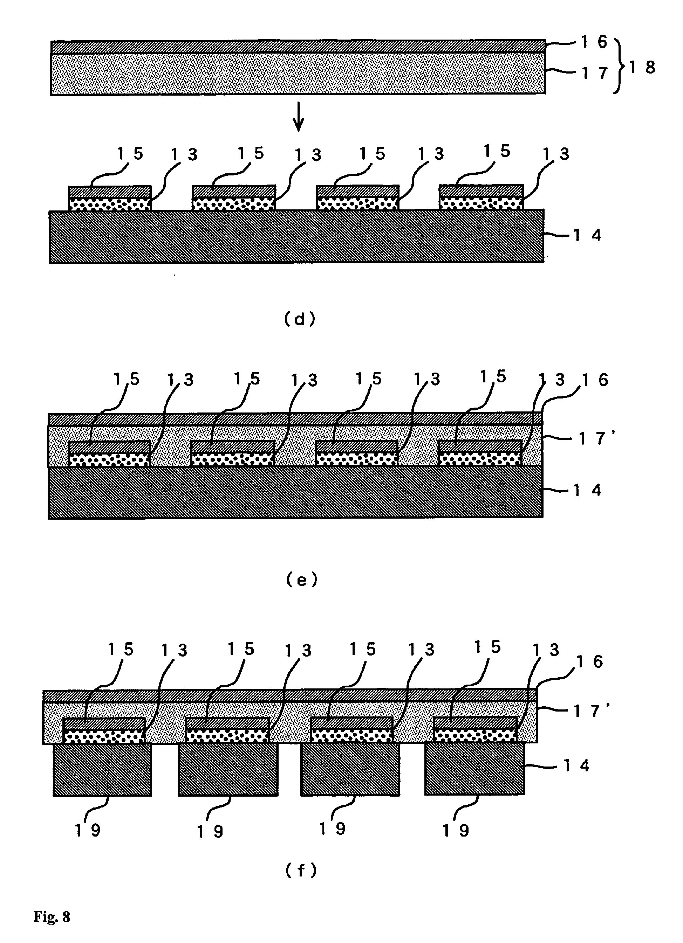

Gaps between the top electrodes which have been deepened by removing the exposed dielectric layer of the capacitor layer forming material after finishing the above mentioned dielectric layer removal is required to be filled. Then, as shown in Figure 8(d), for providing an insulating layer and a conductive layer on the surface of the capacitor layer forming material, a resin coated copper foil 18 having a semi-cured resin layer 17 of approximately 80-micron meter in thickness on one-side of the copper foil 16 is laid thereon followed by hot pressing under a heating condition of 180-deg.C for 60 min to laminate the copper foil layer 16 and the insulating layer 17' on the outer layer and to be a state shown in Figure 8(e). Then, a second conductive layer 14 of the outer layer shown in Figure 8(e) is etched to form a bottom electrode 19 and to be a state shown in Figure 8(f).

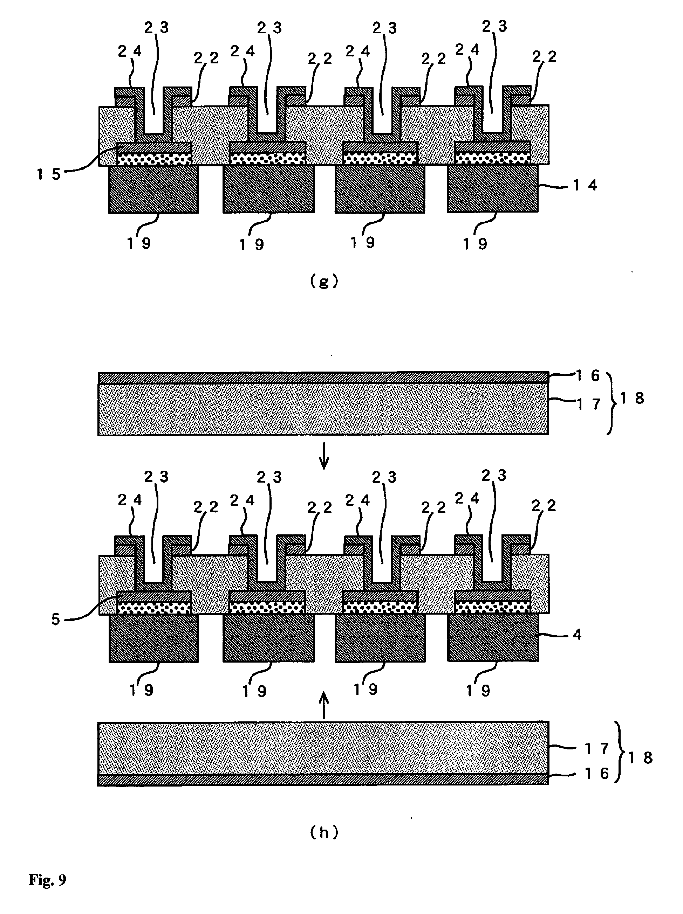

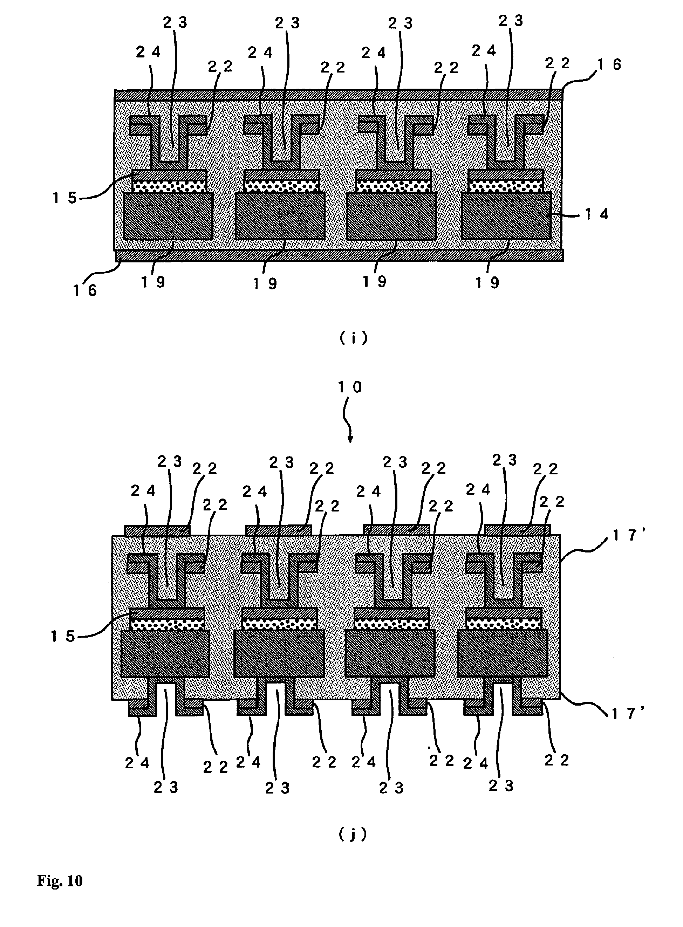

Next, hole making is carried out in the copper foil layer 16 located at the outer layer by the laser processing followed by providing a copper plating layer 24 by the copper plating followed by forming via holes 23 followed by etching to be a state of Figure 9(g). Then, as shown in Figure 9(h), a resin coated copper foil 18 is laid thereon followed by hot pressing under a heating condition of 180-deg.C for 60 min to laminate a copper foil layer 16 and an insulating layer 17 on the outer layer and to be a state shown in Figure 10(i).

Then, making the hole is carried out in the copper foil layer 16 of the outer layer shown in Figure 10(i) ; a copper plating layer 24 is provided by the copper plating followed by forming via holes 23 followed by etching to be a state of Figure 10(j). The etching method and the formation of via holes at this time can also employ conventional methods. As described above, a printed wiring board 10 equipped with embedded capacitor circuits can be manufactured. It is roughly stated here that the manufacture of the printed wiring board according to the present invention should not be limited to the above-mentioned manufacturing method, and can employ every manufacturing method. Hereinafter, examples will be described.

### [Example 1]

In this example, the above-mentioned oxide dielectric layer was formed on the surface of a nickel foil as a metal substrate (bottom electrode forming layer) ; and a top electrode forming layer was provided on the surface of the dielectric layer to manufacture a capacitor layer forming material. Then, capacitor circuits were formed by etching using the capacitor layer forming material; and dielectric characteristic were evaluated.

### <Manufacture of a metal substrate (bottom electrode forming layer)>

A nickel foil, manufactured by the rolling method, of 50-micron meter in thickness was used. The thickness of the nickel foil manufactured by the rolling method was denoted as a gauge thickness. This nickel foil constitutes a second conductive layer when made to be a capacitor layer forming material.

### <Formation of dielectric layers>

A dielectric layer was formed on the surface of the nickel foil by applying the sol-gel method. Before the dielectric layer was formed by applying the sol-gel method, the nickel foil was subjected to heating at 250-deg.C for 15 min followed by irradiation of ultraviolet rays for 1 min as a pretreatment to clean the surface.

Process (a) : In this solution preparing process, a sol-gel solution used for the sol-gel method was prepared. The sol-gel solution was prepared such that an oxide dielectric layer of a composition of Ba_{0.7}Sr_{0.3}TiO₃ can be obtained using 7-wt% BST of trade name: BST thin film forming agent, manufactured by Mitsubishi Materials Corp.

Process (b) : In this process, wherein stages of the sol-gel solution coating on the surface of a metal substrate followed by drying in an oxygen-containing atmosphere followed by pyrolysis in an oxygen-containing atmosphere sequentially are made one unit step. In repeating of the one unit step six times, a pre-baking stage, of at least once between one unit step and one unit step, at 650-deg.C for 15 min in an inert gas-substituted atmosphere was provided to control the film thickness. Then, plural samples of Sample 1-1 to Sample 1-8, were obtained.

Regarding to Sample 1-1 and Sample 1-2, the pre-baking stage was provided once between the first one unit step and the second one unit step.
Regarding to Sample 1-3, the pre-baking stage was provided once between the second one unit step and the third one unit step.
Regarding to Sample 1-4, the pre-baking stage was provided once between the third one unit step and the fourth one unit step.
Regarding to Sample 1-5, the pre-baking stage was provided once between the fourth one unit step and the fifth one unit step.
Regarding to Sample 1-6, the pre-baking stages were provided twice between the first one unit step and the second one unit step and between the third one unit step and the fourth one unit step.
Regarding to Sample 1-7 and Sample 1-8, the pre-baking stages were provided five times between each one unit step from the first one unit step to the sixth one unit step.

Process (c) : Each of Sample 1-1, Sample 1-3, Sample 1-4, Sample 1-5 Sample 1-6 and Sample 1-7 was subjected to a baking process at 650-deg.C for 15 min in an inert gas-substituted atmosphere (nitrogen-substituted atmosphere) to form a dielectric layer on the surface of the nickel foil as a metal substrate. Each of Sample 1-2 and Sample 1-8 was subjected to a baking process at 700-deg.C for 30 min in an inert gas-substituted atmosphere (nitrogen-substituted atmosphere) to form a dielectric layer on the surface of the nickel foil as a metal substrate.

### <Formation of a top electrode>

On the dielectric layer formed in each sample as described above, a copper layer of 2-micron meter in thickness was formed as a first conductive layer by the sputtering deposition method to prepare eight types of capacitor layer forming materials each having the first conductive layer and the second conductive layer on both surfaces of the dielectric layer.

### <Formation of capacitor circuits>

An etching resist layer was provided on the surface of the first conductive layer of the each capacitor forming material; and an etching pattern was exposed for forming a top electrode shape, and the etching resist layer was developed. Thereafter, the first conductive layer was etched with a copper chloride base copper etching solution, and the etching resist was released to form 100 pieces of capacitor circuits whose top electrode area was 1 mm x 1 mm and 100 pieces thereof whose top electrode area was 4 mm x 4 mm.

### <Evaluation of dielectric characteristics>

Yield of electrodes: After the formation of the capacitor circuits, a predetermined voltage was applied to the 100 capacitor circuits of each sample to carry out the interlayer break down voltage test and a ratio in which no short circuit phenomenon was observed across the top electrode and the bottom electrode was determined. As a result, the production yield of the capacitor circuit of 1 mm x 1 mm size was 80% to 100% and for 4 mm x 4 mm size was 10% to 83%.

Electric capacitance density: An initial average capacitance density exhibited as very high as 1, 330-nF/cm² to 1,920-nF/cm².

Dielectric loss: The dielectric losses of the capacitor circuits were in the range from 2.2% to 16%.

Dielectric layer remaining after etching: Dielectric layer remaining in gap after forming the capacitor circuits was examined. The presence/absence of the remaining was examined by observing between the circuits by a metallographic microscope. When the dielectric layer remains, the interference rainbow color is observed. As a result, in any of Sample 1-1 to Sample 1-8, the dielectric layer remaining was confirmed.

Crystallization level of the dielectric layer: The surface of the dielectric layer was examined by the X-ray diffractiometry (CuK-alpha) to determine a full width half maximum of the peak of the (101) plane indexed by the tetragonal structure to evaluate the crystallization level. As a result, the value was 0.268 deg to 0.299 deg. According to the result, if the full width half maximum of the peak of the (101) plane is not more than 0.3 deg, the samples are regarded to have been successfully crystallized in practical use. Also in Example 2 below, the same process was employed to the formation of a dielectric layer. Therefore, it is expressly stated here that a full width half maximum of the peak of the (101) plane were the same value.

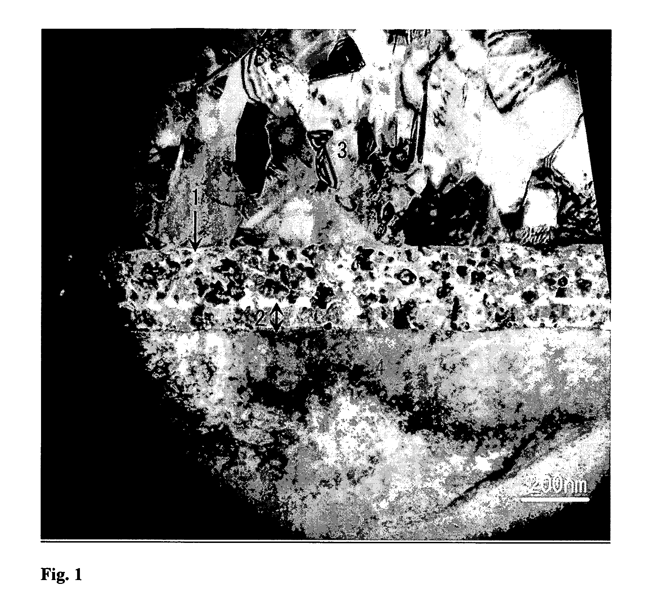

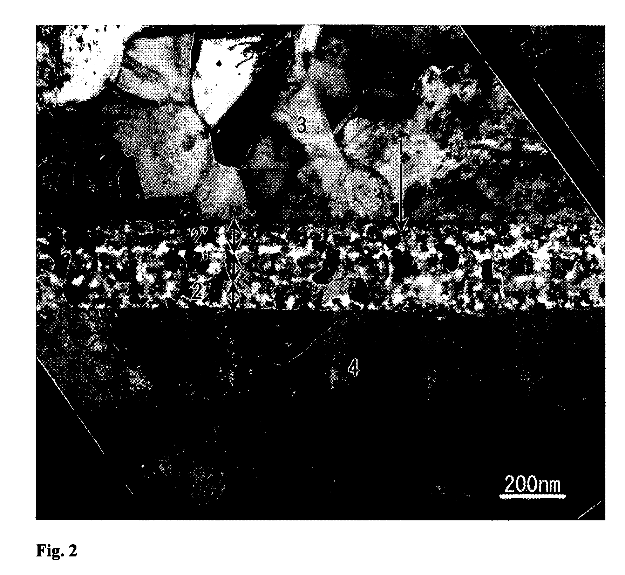

Examination of the dielectric layer by a transmission electron microscope: The cross-sections of the capacitor layer forming materials of Sample 1-1 and Sample 1-6 were processed with focused ion beam and observed by a transmission electron microscope. The observed images are shown in Figure 1 and Figure 2. As is clear from Figure 1, which is a cross-sectional image of Sample 1-1, in a dielectric layer 1 between a top electrode 3 and a bottom electrode 4, the first layer 2 which was subjected to the pre-baking after finishing of one unit step is observed to be clearly distinguished from the other layers. In Figure 2, which is a cross-sectional image of Sample 1-6, the dielectric layer is observed to be likely divided into three layers (first layer 2, second layer 2', third layer 2")

As described above, in the cross-sectional image (Figure 1) of Sample 1-1, the first layer 2 is observed to be clearly distinguished from the other layers. In contrast, in the cross-sectional image (Figure 2) of Sample 1-6, although the dielectric layer looks to be divided into three layers but three layers cannot be seen clearly, because the crystal grains seem to have columnarly grown as compared with Sample 1-1. However, the present inventors believe, from the various view points such as effective prevention of the leak current, that the dielectric layer without defects such as voids is preferable. In such a consideration, the layered parts are believed to contain many defects such as voids, so it is preferable that layers cannot be clearly seen. Here, investigating the cross-section of Sample 1-7 and comparing with the cross-sectional image (Figure 2) of Sample 1-2, the crystal grains are recognized to have further columnar growth and the dielectric layer exhibits almost no discontinuity according to the every pre-baking. That is, judging from the preparing conditions of these samples, it can be supposed that by setting the final crystallization temperature to be high and the time to be long for Sample 1-1 and Sample 1-6, the interlayer continuity also for the thickness direction of a dielectric layer can be formed uniform.

The characteristics described above are summarized in Table 1 so as to be compared with Comparative Example 1 described later.

### [Example 2]

In this example, an above-mentioned oxide dielectric layer was formed on the surface of a nickel foil as a metal substrate (bottom electrode forming layer); and atop electrode was formed on the surface of the dielectric layer by using the masking method to make capacitor circuits, whose various dielectric characteristics were evaluated.

### <Manufacture of a metal substrate (bottom electrode forming layer)>

Here, as in Example 1, a nickel foil of 50-micron meter in thickness manufactured by the rolling method was used. The nickel foil was to constitute a bottom electrode when capacitor layer circuits were formed.

### <Formation of a dielectric layer>

The dielectric layer was formed on the surface of the nickel foil by applying the sol-gel method and the sol-gel solution similar to Example 1. Therefore, a dielectric layer similar to Example 1 is supposed to have been formed, so the duplicate description herein will be omitted. Plural samples of Sample 2-1 to Sample 2-8 were obtained.

Regarding to Sample 2-1 and Sample 2-2, the pre-baking stage was provided once between the first one unit step and the second one unit step.
Regarding to Sample 2-3, the pre-baking stage was provided once between the second one unit step and the third one unit step.
Regarding to Sample 2-4, the pre-baking stage was provided once between the third one unit step and the fourth one unit step.
Regarding to Sample 2-5, the pre-baking stage was provided once between the fourth one unit step and the fifth one unit step.
Regarding to Sample 2-6, the pre-baking stages were provided twice between the first one unit step and the second one unit step and between the third one unit step and the fourth one unit step.
Regarding to Sample 2-7 and Sample 2-8, the pre-baking stages were provided five times between each one unit step from the first one unit step to the sixth one unit step.

Process (c) : Each of Sample 2-1, Sample 2-3, Sample 2-4, Sample 2-5 Sample 2-6 and Sample 2-7 was subjected to a baking process at 650-deg. C for 15 min in an inert gas-substituted atmosphere (nitrogen-substituted atmosphere) to form a dielectric layer on the surface of the nickel foil as metal substrate. Another each of Sample 2-2 and Sample 2-8 was subjected to a baking process at 700-deg.C for 30 min in an inert gas-substituted atmosphere (nitrogen-substituted atmosphere) to form a dielectric layer on the surface of the nickel foil as metal substrate.

### <Formation of capacitor circuits>

On the dielectric layer formed in each sample described above, a deposition metal mask which has open in a top electrode shape at a position where a top electrode was to be formed was put and a copper layer of 2-micron meter in thickness was formed as a top electrode by the sputtering deposition method to form capacitor circuits. At this time, 100 pieces of capacitor circuits whose top electrode area was of 1 mm x 1 mm size and 100 pieces thereof whose top electrode area was of 4 mm x 4 mm size, were formed.

### <Evaluation of dielectric characteristics>

Yield of electrodes: After the formation of the capacitor circuits, a predetermined voltage was applied to the 100 capacitor circuits of each sample to carry out the interlayer break down voltage test and a ratio in which no short circuit phenomenon was observed across the top electrode and the bottom electrode was determined. As a result, the production yield of the capacitor circuit of 1 mm x 1 mm size was 60% to 100% and fro 4 mm x 4 mm size was 10% to 70%.

Electric capacitance density: An initial average capacitance density exhibited as very high as 1,040-nF/cm² to 1,710-nF/cm².

Dielectric loss: The dielectric losses of the capacitor circuits were in the range from 2.8% to 7.5%.

Crystallization level of the dielectric layer: The description will be omitted because it was similar to Example 1.

Electric characteristics described above were measured by a 4261A LCR meter (1 kHz, 1V), made by Hewlett Packard Development Corp. Summary is shown in Table 2 so as to be compared with Comparative Example 2 described later.

### [Comparative Examples]

### [Comparative Example 1]

Comparative Example 1 employed a manufacturing flow similar to Example 1, but process (b) and process (c) has difference. Therefore, the different processes only will be described.

Process (b): Stages of the sol-gel solution coating on the surface of a metal substrate followed by drying in an oxygen-containing atmosphere followed by pyrolysis in an oxygen-containing atmosphere sequentially is made one unit step. Then, the one unit step was repeated six times to control the film thickness. Then, three samples were prepared.

Process (c) : One of the above-mentioned samples was subjected to a baking process at 650-deg.C for 15 min in an inert gas-substituted atmosphere (nitrogen-substituted atmosphere) to form a dielectric layer on the surface of the nickel foil as a metal substrate to prepare sample 3-1. One of the above-mentioned samples was subjected to a baking process at 650-deg.C for 30 min in an inert gas-substituted atmosphere (nitrogen-substituted atmosphere) to form a dielectric layer on the surface of the nickel foil as a metal substrate to prepare sample 3-2. Further, one of the above-mentioned samples was subjected to a baking process at 700-deg.C for 60 min in an inert gas-substituted atmosphere (nitrogen-substituted atmosphere) to form a dielectric layer on the surface of the nickel foil as a metal substrate to prepare sample 3-3. Then, as in Example 1, capacitor circuits were manufactured using the etching method.

### <Evaluation of dielectric characteristics>

Yield of electrodes: After the formation of the capacitor circuits as in Example 1, a predetermined voltage was applied to the 100 capacitor circuits of each sample to carry out the interlayer break down voltage test and a ratio in which no short circuit phenomenon was observed across the top electrode and the bottom electrode was determined. As a result, the production yield of the capacitor circuit of 1 mm x 1 mm size was 25% to 80% and that of 4 mm x 4 mm size was 0%.

Electric capacitance density: An initial average capacitance density exhibited as very high as 1,715-nF/cm² to 2,090-nF/cm².

Dielectric loss: The dielectric losses of the capacitor circuits exceeded 20%.

Dielectric layer remaining after etching: As a result of the examination as in Example 1, the dielectric layer did not remain in any case of Sample 3-1 to Sample 3-3.

Crystallization level of the dielectric layer: As in Example 1, the X-ray diffractiometry (CuKα) was examined to determine a full width half maximum of the peak of the (101) plane indexed by the tetragonal structure to be an index of the crystallization level. As a result, the value was 0.337 deg to 0.683 deg. Also in Comparative Example 2 described later, the same process was employed for formation of a dielectric layer. Therefore, it is expressly stated here that the value of full width half maximum of the peak of the (101) plane were the same values.

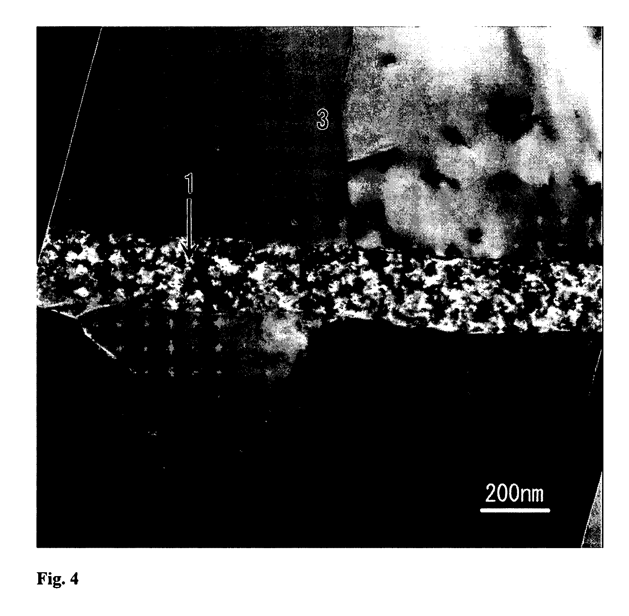

Observation of the dielectric layer by a transmission electron microscope: The cross-section of the capacitor layer forming material of Sample 3-1 was observed by a transmission electron microscope after processing by focused ion beam as in Example 1. The observed image is shown in Figure 4. As it is clear from Figure 4 which is a cross-section of Sample 3-1, the dielectric layer 1 has a crystal grain size of not more than 50-nano meter, and it is observed to be constituted of very fine crystals.

The characteristics described above are summarized in Table 1 so as to be compared with Example 1 described above.

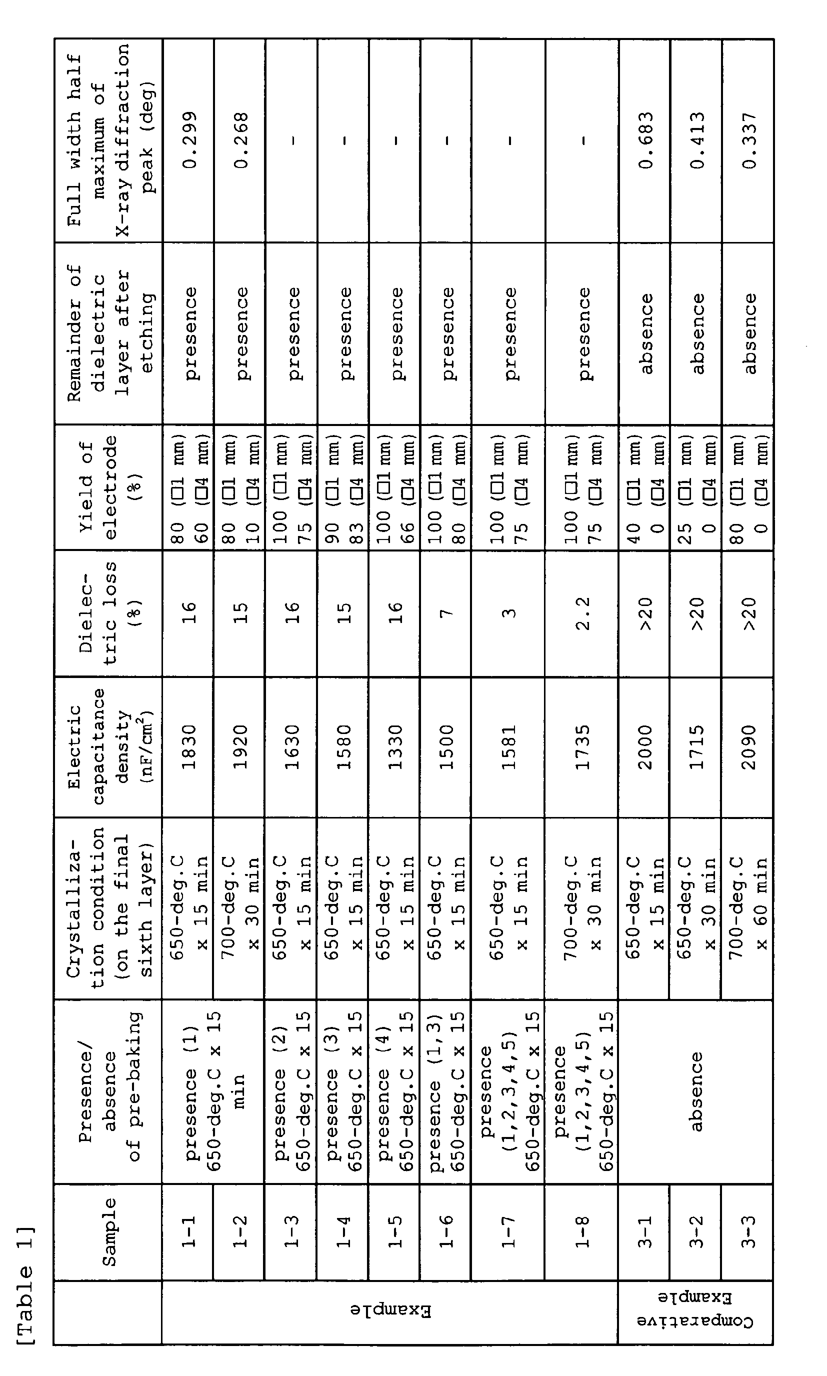

### [Comparative Example 2]

Comparative Example 2 employed a manufacturing flow similar to Example 2, but process (b) and process (c) has difference. Therefore, the different processes only will be described.

Process (b): A sequential stage wherein the above-mentioned sol-gel solution was applied on the surface of a nickel foil of a metal substrate followed by drying at 150-deg. C for 2 min in an oxygen-containing atmosphere followed by pyrolysis at 330-deg. C for 15 min in an oxygen-containing atmosphere, was made to be one unit step. Then, the one unit step was repeated six times to control the film thickness. Then, three samples were prepared.

Process (c): One of the above-mentioned samples was subjected to a baking process at 650-deg.C for 15 min in an inert gas-substituted atmosphere (nitrogen-substituted atmosphere) to form a dielectric layer on the surface of the nickel foil as a metal substrate to prepare sample 4-1. One of the above-mentioned samples was subjected to a baking process at 650-deg.C for 30 min in an inert gas-substituted atmosphere (nitrogen-substituted atmosphere) to form a dielectric layer on the surface of the nickel foil as a metal substrate to prepare sample 4-2. Further, one of the above-mentioned samples was subjected to a baking process at 700-deg.C for 60 min in an inert gas-substituted atmosphere (nitrogen-substituted atmosphere) to form a dielectric layer on the surface of the nickel foil as a metal substrate to prepare sample 4-3. Then, as in Example 2, capacitor circuits were manufactured by using the masking method.

### <Evaluation of dielectric characteristics>

Yield of electrodes: After the formation of the capacitor circuits, a predetermined voltage was applied to the 100 capacitor circuits of each sample to carry out the interlayer break down voltage test and a ratio in which no short circuit phenomenon was observed across the top electrode and the bottom electrode was determined. As a result, the production yield of the capacitor circuit of 1 mm x 1 mm size was 50% to 90% and for 4 mm x 4 mm size was 0% to 20%.

Electric capacitance density: An initial average capacitance density exhibited as very high as 1,010-nF/m² to 1,240-nF/cm².

Dielectric loss: The dielectric losses of the capacitor circuits were in the range from 5% to 8%.

Crystallization level of the dielectric layer: The crystalline level was the same in Comparative Example 1, so the description is omitted.

The characteristics described above are summarized in Table 2 so as to be compared with Example 2 described above.

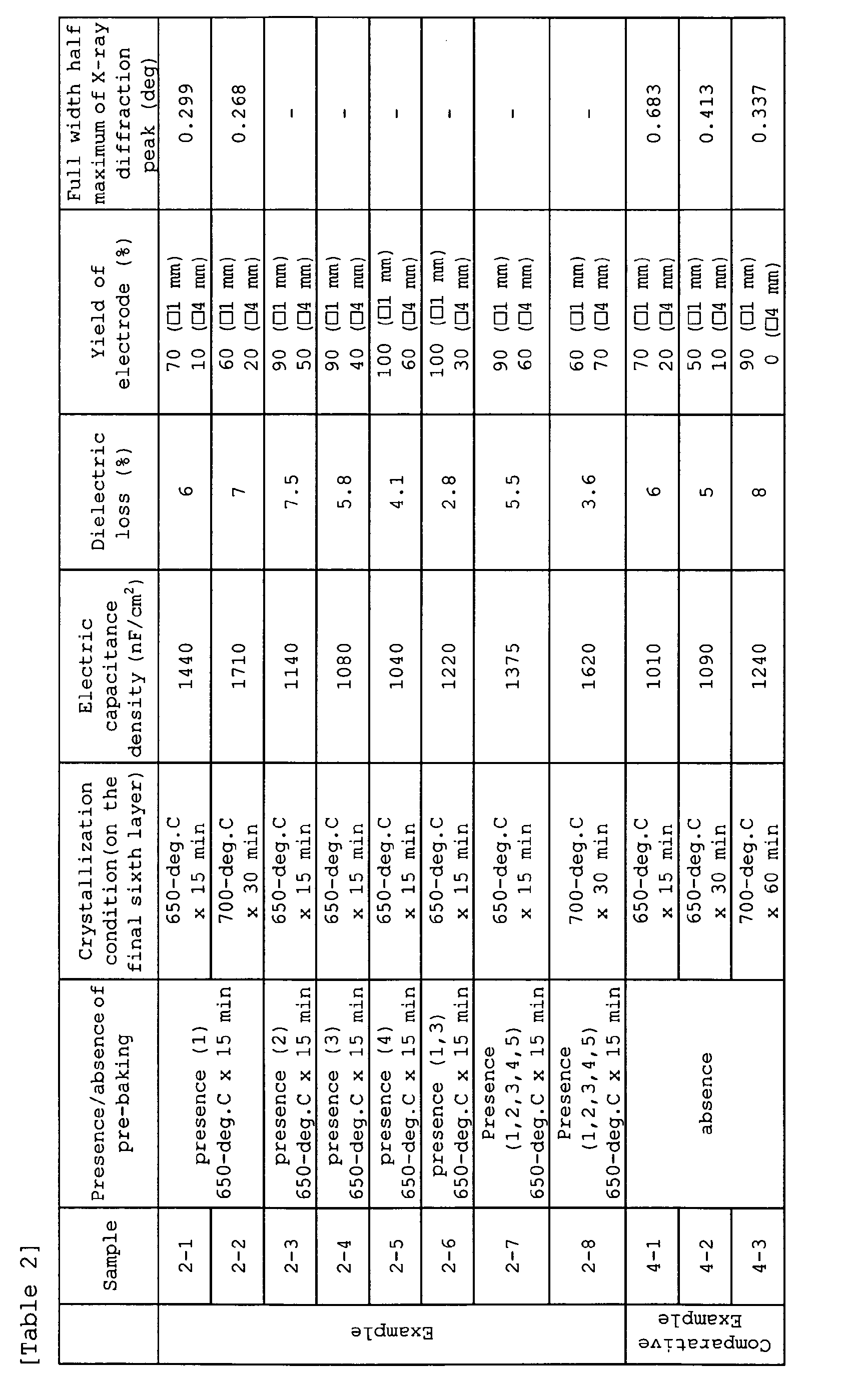

### <Comparison of Examples and Comparative Examples>

Here, on comparison of Examples and Comparative Examples, the reason why Examples and Comparative Examples used both the etching method and the masking method for the formation of the capacitor shape will be described. The essential effect of the pre-baking in the manufacturing method according to the present invention lies in the point to prevent the dielectric layer itself from the damage (specifically, the dielectric layer disappears) caused by the damage of substrate brought about by penetrating etching solution through the dielectric layer film during the etching. For the purpose that only this phenomenon is intended to be examined, only the evaluation of the results of capacitors fabricated by the etching method is enough.

However, the reason why the additional formation of capacitors was carried out by the masking method and the evaluation results are shown is to disclose superiority in the capacitance density of the capacitor circuits obtained by employing the pre-baking stage, because the capacitance density by the etching method has less reliability in the evaluation. That is, the etching method has a tendency of providing a large dielectric loss and a large leak current due to the damage in the dielectric layer. The capacitance density in such a case cannot be believed to be a true capacitance density, but the capacitors obtained not by etching but by the masking method are believed to exhibit actual dielectric characteristics rather than the etching method.

Comparison of Example 1 and Comparative Example 1: Example 1 and Comparative Example 1 are the evaluation results when capacitor circuits were formed by using the etching method. As is clear from Table 1, seeing the electric capacitance density only, Comparative Example 1 (Sample 3-1 to Sample 3-3) has higher densities than Example 1 (Sample 1-1 to Sample 1-8). However, seeing the dielectric loss, the dielectric losses of Comparative Example 1 (Sample 3-1 to Sample 3-3) exceed 20%, and lack in the stability as a capacitor is evident. In contrast, the dielectric losses of Example 1 (Sample 1-1 to Sample 1-8) are not more than 16%; and Example 1 achieves a high capacitance in a certain level, and is clearly excellent in the quality stability as a capacitor.

Seeing the production yields after the formation of the capacitor circuits by the etching method, Example 1 (Sample 1-1 to Sample 1-8) has higher production yields than Comparative Example 1 (Sample 3-1 to Sample 3-3), and also an excellent production stability is evident. Further comparing the crystallization levels of the dielectric layers, Example 1 (Sample 1-1 to Sample 1-8) has smaller full width half maximums than Comparative Example 1 (Sample 3-1 to Sample 3-3), and clearly provides sharp diffraction peaks. This may resulted by an improved crystallization level, a dense oxide dielectric layer constituting the dielectric layer, a high film density, and few structural defects. Even if the baking carried out finally with long baking time may be applied like the cases of Sample 3-1 to Sample 3-3, unless the pre-baking stage is provided as Sample 1-1 to Sample 1-8 underwent, the improved crystallinity cannot be achieved.

Then, as is clear from the observation of the dielectric layers by a transmission electron microscope, since the dielectric layers of the capacitor layer forming materials of Sample 1-1 and Sample 1-3 have large and dense crystals, they have only a few flow paths for the leak current and a low ability for penetrating of an etching solution. In contrast, since Sample 3-1 of Comparative Example 1 is constituted of very fine crystals, without dense crystals and with many structural defects, it has many flow paths for the leak current and a high permeability of an etching solution.

Further, regarding to the ability for penetrating of an etching solution through the dielectric layer, as a result of examination of whether the dielectric layer remains or not in gaps between circuits after the capacitor circuits were formed, in any case of Sample 1-1 to Sample 1-8 of Example 1, dielectric layer remaining was confirmed. In contrast, in any case of Sample 3-1 to Sample 3-3 of Comparative Example 1, no dielectric layer remaining was confirmed. This substantiates the hypothesis built up from the observed images by a transmission electron microscope.

Comparison of Example 2 and Comparative Example 2: Example 2 and Comparative Example 2 are evaluation results when the capacitor circuits were formed by using the masking method. As is clear from Table 2, seeing the electric capacitance density, Comparative Example 2 (Sample 4-1 to Sample 4-3) has a relatively small density than Example 2 (Sample 2-1 to 2-8). On the other hand, seeing the dielectric loss, Comparative Example 2 (Sample 4-1 to Sample 4-3) can be said to have dielectric losses in the same level as Example 2 (Sample 2-1 to 2-8). However, in consideration of a balance between the electric capacitance density and the dielectric loss, Example 2 achieves a larger capacitance in a certain level and is clearly excellent in the quality stability as a capacitor.

Describing more exactly and specifically the above-mentioned contents, the dielectric layer which was once subjected to the pre-baking which was carried out between the first one unit step and the second one unit step has a low dielectric loss and can obviously be said to have a more excellent capacitance density than any samples of Comparative Example 2. In contrast, the dielectric layer whose baking stage was set at the second layer, third layer or fourth layer cause no change in dielectric loss, but show less distinct difference in capacitance density from Comparative Example 2. In other words, as the number of unit step proceeded before the pre-baking is carried out increase, the capacitance density looks to have a tendency of decreasing. That is, comparing them in the condition of one-time pre-baking, the pre-baking at an earlier step in the film forming cycle is judged to be preferable for exhibiting an excellent improved effect on electric characteristics from above data. In contrast, the fact that the capacitance density decreases as the execution of pre-baking becomes later is rationalized in the way that the baking condition in terms of the half film thickness becomes to close to that of comparative examples.

Then, seeing the production yield after the formation of the capacitor circuits by the masking method, Example 2 (Sample 2-1 to Sample 2-8) has higher yields than Comparative Example 2 (Sample 4-1 to Sample 4-3), and an excellent production stability is evident also. Further, comparing the crystallization levels of the dielectric layers, Example 2 (Sample 2-1 to Sample 2-2) has small full width half maximums than Comparative Example 2 (Sample 4-1 to Sample 4-3), and clearly provides a sharp diffraction peak. It means that the dielectric layer has improved crystallinity, and then the oxide dielectric layer constituting the dielectric layer is dense and has a higher film density and fewer structural defects. When baking is carried out finally as the cases of Sample 4-1 to Sample 4-3, the improved crystallinity cannot be obtained without pre-baking stage as was carried out for samples 2-1 to samples 2-8 even if the baking time is extended further.

Example 2 and Comparative Example 2 are the cases where the capacitor circuits were formed by the masking method. Seeing the whole data in such cases, if the dielectric losses are similar level in both with or without pre-baking, the presence of the pre-baking provides an excellent crystallinity, i.e., a high capacitance density (Different from the etching method, capacitance densities show linear tendency with the full width half maximums in the masking method. That is, smaller the full width half maximum, larger the capacitance density.). Although heat treatment of 650-deg.C x 15 min + 650-deg.C x 15 min including pre-baking provides smaller thermal energy than heat treatment of 700-deg.C x 60 min without pre-baking, the former is believed to result in a better crystallinity and capacitance density.

Comparison of the etching method and the masking method: The etching method and the masking method used for finishing in Examples and Comparative Examples described above will be compared. When capacitor circuits are formed by the etching method, Comparative Example 1 shows a remarkable rise in the dielectric loss and a decrease in the electrode yield which may due to damage by an etching solution when compared with Example 1. When capacitor circuits are formed by the masking method, the rise in dielectric loss does not occur even in Comparative Example 2. However, regarding to the capacitance density and the yield of electrodes, Example 2 is excellent. Comparing the evaluation results of the capacitor circuits formed by the etching method and the masking method in such ways clarifies that the dielectric layer according to the present invention not only allow reduced etching damage but exhibits an improved quality.

### Industrial Applicability

The method for forming oxide dielectric layers by applying the sol-gel method according to the present invention allows the formation of high-quality oxide dielectric layers in a high yield, and allows supply of various electronic materials having high-quality dielectric layers in markets. Further, the method for forming oxide dielectric layers by applying the sol-gel method according to the present invention allows the manufacture of oxide dielectric layers applying the sol-gel method without excessive investments for facilities. Therefore, the high-quality and inexpensive electronic and electric products can be commercially provided. The dielectric layers obtained by the method for forming oxide dielectric layers according to the present invention have a characteristic of being hardly damaged by an etching solution, and are suitable especially for forming capacitor circuits by the etching method. It means that the capacitor layer forming material which dielectric layer is formed by using the forming method of oxide dielectric layers by applying the sol-gel method according to the present invention is suitable for forming capacitor layers of printed wiring boards, and it enables manufacture of capacitor circuits exhibiting a high electric capacitance and a low dielectric loss. Therefore, printed wiring boards and the like obtained by using the capacitor layer forming material serve to the power saving of electronic and electric products.

## Claims

1. A method for forming an oxide dielectric layer by applying a sol-gel method, which is **characterized in** being provided with the following processes (a), (b) and (c):
(a) a solution preparing process of preparing a sol-gel solution for manufacturing an aiming oxide dielectric layer;
(b) a coating process of controlling a film thickness wherein sequential one unit step in which the sol-gel solution is applied on a surface of a metal substrate followed by drying at 120-deg.C to 250-deg.C in an oxygen-containing atmosphere and pyrolyzed at 270-deg.C to 390-deg.C in an oxygen-containing atmosphere, and in repeating of the one unit step twice or more times, a pre-baking stage at 550-deg.C to 1000-deg.C in an inert gas-substituted atmosphere or in vacuum is provided between the unit steps optionally; and
(c) a baking process of finally subjecting the coated metal substrate to a baking process at 550-deg.C to 1000-deg.C in an inert gas-substituted atmosphere or in vacuum to finish the dielectric layer.

2. The method for forming an oxide dielectric layer according to claim 1, wherein the sol-gel solution is to form a (Ba₁₋ₓSrₓ)TiO₃ (0 <= x <=1) film or a BiZrO₃ film as the oxide dielectric layer.

3. The method for forming an oxide dielectric layer according to claims 1 or 2, wherein the sol-gel solution to form the oxide dielectric layer contains 0.01 mol% to 5.00 mol% of one or a mixture selected from manganese, silicon, nickel, aluminum, lanthanum, niobium, magnesium and tin.

4. The method for forming an oxide dielectric layer according to any one of claims 1 to 3, wherein the thickness of the dielectric layer is 20-nano meter to 2-micron meter.

5. Themethod for forming an oxide dielectric layer according to any one of claims 1 to 4, wherein the metal substrate is anyone of a nickel foil, a nickel alloy foil, a composite foil having a nickel layer on its surface and a composite foil having a nickel alloy layer on its surface, which have a thickness of 1-micron meter to 100-micron meter.

6. The method for forming an oxide dielectric layer according to claim 5, wherein the nickel alloy foil or the nickel alloy layer of the composite foil having the nickel alloy layer on its surface is nickel-phosphorus alloy.

7. A capacitor layer forming material in which a dielectric layer is provided between a first conductive layer used for forming a top electrode and a second conductive layer used for forming a bottom electrode, **characterized in that** the dielectric layer is obtained by the method for forming an oxide dielectric layer according to any one of claims 1 to 6.

8. A printed wiring board **characterized in** being provided with an embedded capacitor layer obtained by using the capacitor layer forming material according to claim 7.
